# NEW EUROPEAN PATENT SPECIFICATION

(11) **EP 0 254 560 B2**
(45) Date of publication and mention of the opposition decision: **03.05.2000**
(45) Mention of the grant of the patent: 04.03.1992
(21) Application number: 87306501.5
(22) Date of filing: 23.07.1987
(51) Int. Cl.: C30B 25/02, C30B 29/04

(54) **Gaseous phase synthesized diamond and method for synthesizing same**
Aus der Gasphase hergestellter Diamant, sowie Verfahren zu dessen Herstellung
Diamant fabriqué en phase gazeuse et son procédé de production

(30) Priority: 23.07.1986 JP 17336586; 27.03.1987 JP 7528287; 13.05.1987 JP 11659887
(43) Date of publication of application: 27.01.1988
(73) Proprietor: SUMITOMO ELECTRIC INDUSTRIES LIMITED, Osaka-shi, Osaka 541 (JP)
(72) Inventor: Ikegaya, Akihiko Itami Works, Itami-shi Hyogo (JP); Tobioka, Masaaki Itami Works, Itami-shi Hyogo (JP)
(74) Representative: Warren, Anthony Robert

(56) References cited:
- JOURNAL OF APPLIED PHYSICS, vol. 58, no. 4, August 1985, pages 1693-1695, American Institute of Physics, Woodbury, New York, US; M. KITABATAKE et al.: "Growth of diamond at room temperature by an ion-beam sputter deposition under hydrogen-ion bombardment"
- APPLIED PHYSICS LETTERS, vol. 29, no. 2, 15th July 1976, pages 118-120, American Institute of Physics, New York, US; E.G. SPENCER et al.: "Ion-beam-deposited polycrystalline diamondlike films"
- PATENT ABSTRACTS OF JAPAN, vol. 9, no. 278 (C-312)[2001], 6th November 1985; & JP-A-60 122 794 (MITSUBISHI KINZOKU K.K.) 01-07-1985
- Japanese Journal of Applied Physics, vol. 25, no. 6, June 1986, pp. L519-521
- Japanese Journal of Applied Physics, vol. 21, no. 4, April 1982, pp. L183-185
- Proc. of the 9th Symp. on ISAT '85, Tokyo 1985, pp. 233-236
- Proc. of the 9th Symp. on ISAT '85, Tokyo 1985, pp. 223-228
- Refractory Materials & Hard Materials, vol. 11 (1992) p. 259-269

## Description

The present invention relates to a method for synthesizing gaseous phase synthesized diamond. In particular, the invention results in crystalline diamond having a remarkably high completeness and containing hardly any carbon having a form other than that of diamond.

In addition, the present invention relates to high-speed synthesization of a diamond film, capable of coating diamond at a high-speed of 10 times to several tens of times the deposition speed of diamond in the prior art by using such a method.

Diamond has previously been synthesized at high temperatures and pressures and, as a result, its manufacturing cost has been high. However, recently, a low-pressure gaseous phase synthesizing method, in which diamond is synthesized at low pressures without using high pressures, has been developed.

The following gaseous phase diamond-synthesizing methods have been known.
(1) High-frequency plasma CVD (Chemical Vapour Deposition) methods using a plasma disclosed in JP-A-58-135117, JP-A-61-8458 and 61-8459, and microwave plasma CVD methods disclosed in JP-A-58-110494 and 59-3098, and US-A-4,434,188.
(2) An ionization vapor deposition method and an ion beam vapor deposition method using ion particles.
(3) A thermoelectron radiation CVD method using neutral particles disclosed in JP-A-58-91100.
(4) CVD methods using an electron shock disclosed in JP-A-60-221395 and EP-A-161,829.

Of these, methods (1) and methods (3) are capable of synthesizing a crystalline diamond film while methods (2) are capable of obtaining an amorphous diamond-like carbon film. In addition, methods (4) are superior to other methods and are characterised by a growth speed of diamond film which is large, to a extent of 3 to 5 µm/hr, and by an initial diamond nucleus-forming speed which is increased.

However, this is found in the case where a ratio of CH₄ to H₂ by volume, that is to say a CH₄/H₂, is increased. In this case, according to the evaluation by the Raman spectrometric method, problems have occurred, in that a peak of 1,550 cm⁻¹ relating to amorphous carbon is increased and the resulting diamond film has a low completeness.

This has been disclosed in the Journal of Applied Physics, Vol. 55, page 640 (1986).

Also the film growth speed is insufficient for the provision of a bulk material.

As to a crystalline diamond film, its applications have been energetically investigated in relation to the surface coating of abrasion-resisting parts and the surface coating film of cutting tools due to its remarkably high hardness, to a heat sink member for a semiconductive device due to its high thermal conductivity, and to a semiconductive element by doping impurities due to an increased band gap.

Of the above described prior art, if the microwave plasma CVD method is used, diamond containing hardly any carbon (amorphous carbon, graphite and the like) having a form other than that of diamond discriminated by the Raman spectrometric method or the like, and having a remarkably large electrical resistance and a high completeness, can be obtained. However, in a method, in which the microwave non-polar discharge is produced in a reaction tube passing vertically through a wave-guide tube, which has usually been used, since a microwave has a short wave length, if a reaction tube having a diameter longer than the wave length of the microwave is used, the microwave cannot be blocked but leaks out, so that the size of the reaction tube is restricted by the wave length. As a result, the coating zone cannot be widened, whereby the mass production becomes difficult.

Thus, if the frequencies which are to be employed are those which can be industrially used in Japan, i.e. 915 MHz and 2,350 MHz, the diameter of the reaction tube has an upper limit of 120 mm and 50 mm, respectively.

Accordingly, such a method is insufficient for the attainment of a coating zone having such a large area that mass production can be industrially carried out. In addition, in the case of an HF plasma CVD method, in order to provide diamond having a high completeness, it is necessary to generate a plasma having a high strength. In the case of a method for generating a plasma, in which only an HF power source is used as an excitation source, only an inductive-coupling type method can be used.

It may be said in this connection that, in a capacitive-coupling type method, an amorphous diamond, not a crystalline diamond, is synthesized. That is to say, in the HF inductive-coupling type method, in order to obtain a coating zone having a large area, an HF power source of large electrical power is required which is particularly difficult to use industrially.

In addition, in CVD methods (4), since a shower of electrons is used, the electrical power which can be applied between the filament and the substrate is limited, and the film growth speed cannot be so increased as in the present invention.

Besides, an electron shock is indispensable in this method, so that if the pressure of the surrounding atmosphere is increased, the shower of electrons does not arrive at the substrate. Therefore, this method has been difficult to realize at a high pressure such as 6.67 to 66.66 KPa (50 to 500 Torr) proposed in the present invention.

On the other hand, in the thermoelectron-radiating material CVD method it is thought that the simultaneous treatment of a large number of substrates, and the provision of coating on a large area, are possible in principle by selecting a thermoelectron-radiating material having various kinds of shape, and using a plurality of thermoelectron-radiating materials. However, problems have occurred in that a ratio of carbon other than diamond contained in the synthesized diamond is larger than that in the microwave plasma CVD method, the synthesized diamond being inferior in completeness, and its electrical resistance being reduced.

On the other hand, the deposition speed for forming diamond having an excellent shape and a high completeness, and containing hardly any impurities other than diamond, is at most 2 µm/hr in the thermoelectron-radiating material CVD method and the microwave plasma CVD method, and 5 µm/hr in the EACVD method for a H₂ - CH₄ raw material gas or the like. In order to obtain diamond having an increased film thickness and polycrystalline diamond in the form of bulk material, a technique for synthesizing diamond at a higher speed has been eagerly desired.

The present inventors energetically investigated a method for synthesizing diamond having the capability of mass production, which is an advantage of the thermoelectron-radiating CVD method, and a film quality equal to that of diamond obtained by the microwave plasma CVD method. As a result, the present invention was achieved.

From one aspect the invention provides a diamond film coated on a substrate, characterised in that an average particle size of diamond is 2µm or less and a half-width of a peak of 1334 cm⁻¹ measured by the Raman spectrometric method is 50 cm⁻¹ or less; in that the surface of the diamond film is mainly a (111)-plane, and in that the coated diamond has an electrical resistivity of 10¹⁰ ohm.cm or more.

The invention also provides a method for synthesizing a diamond film in a low-pressure gaseous phase, in which solid carbon or hydrocarbon, or hydrocarbon containing O, N in a bonding group, or carbon tetrachloride, is used as a carbon source, and a raw material gas mixture of said carbon source and hydrogen is activated to deposit a diamond film on a surface of a substrate heated at 600 to 1,200°C, characterised in that the activation of said raw material gas mixture is carried out by a thermoelectron-radiating material heated at 1,600°C or more, the thermoelectron-radiating material being connected to a negative pole of a direct current power source while the substrate to be coated is connected to a positive pole of the source, the source being used to form a plasma at a plasma current density of 50-1000mA/cm² between the thermoelectron-radiating material and the substrate by applying a direct current voltage, the activation by the thermoelectron-radiating material being used together with the activation by the formation of DC plasma, and a pressure within a reaction vessel, in which the plasma is formed, being set at 6.67 KPa (50 Torr) or more but 66.66 KPa (500 Torr) or less.

The invention further provides a method for synthesizing a diamond bulk material in a low-pressure gaseous phase, in which solid carbon or hydrocarbon, or hydrocarbon containing O, N in a bonding group, or carbon tetrachloride, is used as a carbon source, and a raw material gas mixture of said carbon source and hydrogen, with the ratio of the number of carbon atoms the number of hydrogen atoms in the raw material gas mixture being set at 1% or more but 10% or less, is activated to deposit a diamond bulk material on a surface of a substrate set at 850°C or more but 1,200°C or less, characterised in that the activation of said raw material gas is carried out by a thermoelectron-radiating material set at 2,200°C or more, the thermoelectron-radiating material being connected to a negative pole of a direct current power source, while the substrate to be coated is connected to a positive pole of the source, the source being used to form a plasma between the thermoelectron-radiating material and the substrate by applying a direct current voltage, the electric power to be applied for the formation of DC plasma being set at 50W/cm³ or more per unit volume of DC plasma-forming space, the activation by the thermoelectron-radiating material being used together with the activation by the formation of DC plasma, and a pressure within a reaction vessel, in which the plasma is formed, being set at 6.67 KPa (50 Torr) or more but 66.66 KPa (500 Torr) or less.

A diamond film having a (100) - plane, (110)-plane or the like can be formed according to the conditions, but a diamond film having a (111)-plane is desirable for tools. The electrical resistivity is usually a measure of residual carbon such as amorphous carbon and graphite. The higher the resistivity, the smaller is the quantity of residual carbon such as amorphous carbon and graphite.

In addition, in order to achieve a high-speed coating, the thermoelectron-radiating material is heated to superhigh temperatures of 2,200°C or more, and the DC electrical power is applied at a ratio of 50 W/cm³ per unit volume of plasma-forming space or more. Although a surface of the substrate is heated to high temperatures, the present inventors succeeded in the high-speed coating of diamond having an excellent shape and remarkably high completeness and containing hardly any impurities other than diamond, at a ratio of 20µm/hr or more.

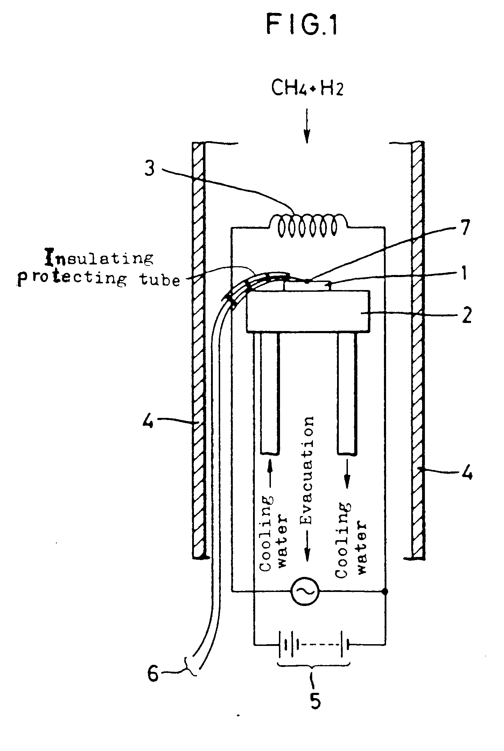

One special feature of the method embodying the present invention is the possibility of the control of the substrate by a cooling mechanism incorporated in a substrate-supporting table, as shown in Fig. 1 of the accompanying drawings. The control of the surface temperature of the substrate, to 850°C or more but 1,200°C or less, is carried out by bringing a CA thermopile fine wire 6 into direct contact , at 7, with a surface of the substrate 1 on the substrate-supporting table 2, whereby the surface temperature of the substrate can be measured with a high degree of accuracy and reproducibility. Thus, the diamond film can be coated on the surface of the substrate under the most suitable and reproducible conditions. In addition, reference numeral 3 designates a thermoelectron-radiating material, reference numeral 4 designates a transparent quartz tube, and reference numeral 5 designates a direct current power source.

As described above, it is particularly important for the manufacture of diamond having a high completeness and preferable characteristics, to control the surface temperature of the substrate.

Also, it is particularly important to control residual stress in the diamond film. In this respect, the coefficient of thermal expansion of diamond is different from that of the substrate. Accordingly, since the temperature at which diamond is synthesized is different from the temperature at which it is used in practice, a residual stress naturally remains in the diamond film.

In the event that the coefficient of thermal expansion of the substrate is larger than that of diamond, a residual compressive stress is generated in the diamond film. If this residual stress is too large, the diamond film will be separated from the substrate. This tendency is enhanced with an increase in the film-thickness.

In addition to the residual stress, generated as a result of the difference between the coefficients of thermal expansion of the substrate and the diamond film, an intrinsic residual stress is generated due to the synthesizing process and the synthesizing conditions. It is preferable for these residual stresses to remain to some extent. The actual residual stress, which is the sum of these two residual stresses, in practice, gives rise to a stronger adhesion between the substrate and film. The reason for this is unclear.

Another characteristic of the method embodying the present invention is that, in the event that an iron group metal is used as the substrate, graphite-like carbon is deposited, but in the event that other substances are used as the substrate, a diamond film having a high adhesion can be obtained.

High-melting point metals, such as V, Nb, Ta, Mo and W, are particularly suitable as the other substrate substances described above, in view of the rise of temperature of the substrate.

Also carbides, nitrides and borides of the IVa-, Va- and VIa-group metals, Al and Si can serve as substrate materials for forming a diamond film having a high adhesion.

In addition, even when using the iron-group metals, if the above described high-melting point metals and various kinds of compounds are preliminarily coated on the substrate, the above described phenomena incidental to the iron-group metals do not occur.

Besides, in the case of carbide alloys and thermets containing iron-group metals, the coating is carried out without problems if the iron-group metals are used in a ratio of 15% by weight or less.

Still another characteristic of the method embodying the present invention is in that an average particle size of diamond coated on the substrate is 2µm or less.

The method embodying the present invention gives rise to a nuclear-generating density of diamond which is remarkably high. That is to say, a carbon radical having a high energy-level is generated by a DC high-energy density plasma and electrons emitted from the thermoelectron-radiating material heated to an extremely high temperature. Thus, the nucleus-generating density of the substrate surface is increased, whereby the average particle size of the resulting diamond film can be maintained at a small value.

Because diamond crystals are gradually grown starting from the nucleus-generating point, they grow in parallel to the surface of the substrate until they are brought into contact with adjacent diamond crystals.

In the case where adhesion is required, such as tools, the heating at temperatures of higher than 600°C, and preferably higher than 950°C, leads to the production of high adhesion between the diamond film and the substrate.

Further, another special feature of the method embodying the present invention is that, since the diamond film is grown at a high-speed, it can also be used as bulky diamond. Various kinds of application can be expected for bulky diamond on account of its superior transmittance of infrared rays and the like, including its application as a transmissive material. Of these applications, the application as a semiconductor is greatly expected. Boron (B), phosphorus (P), sulfur (S), arsenic (As), antimony (Sb) and the like are superior as a dopant for semiconductor diamond, but according to a method embodying the present invention, a bulky diamond material having a functionality can be easily synthesized by forming an atmosphere containing these elements.

On the other hand, homogeneous diamond particles having a uniform shape can be easily obtained by adjusting the nucleus-generating density in the initial deposition stage using this technique.

Various embodiments of the present invention will be described below in detail with reference to the accompanying drawings, in which:-
Fig. 1 is a schematic view showing an application of the DC plasma thermal filament CVD method in which a CA thermocouple fine wire is brought into point contact with a substrate in order to control the surface temperature of the substrate in one embodiment of the present invention;
Figs. 2 and 3 are front views showing one example of an apparatus for carrying out a method of the present invention;
Fig. 4 is a chart according to Raman spectrometric method showing the intensity of diamond film obtained by the present invention.

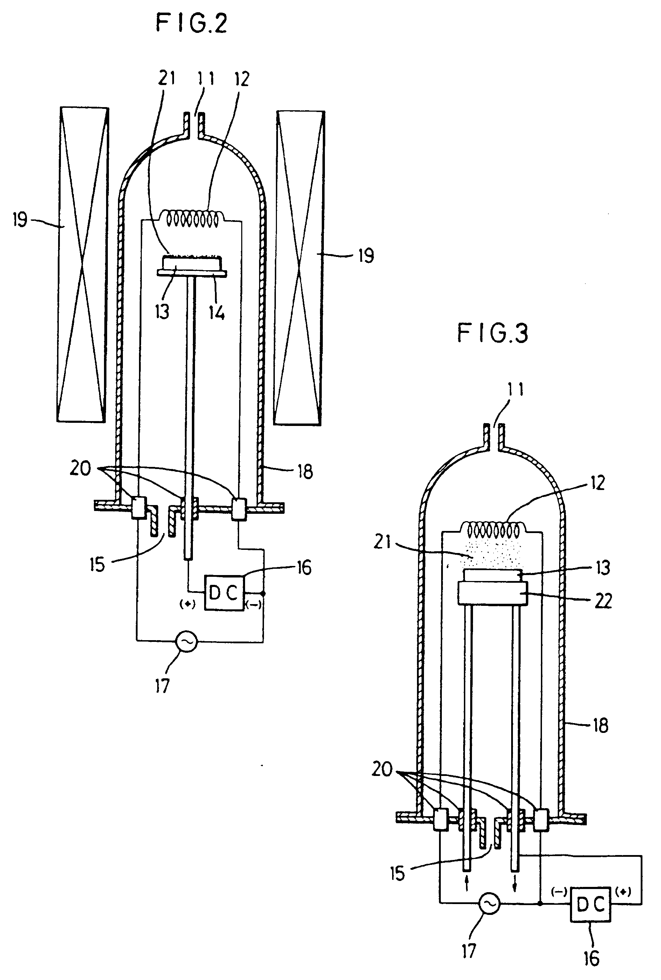

In one preferred embodiment of the apparatus used for carrying out the method of the present invention as shown in Fig. 2, CH₄ and H₂ are introduced into a reaction tube 18 made of quartz through a raw material gas-introducing port 11, and thermally activated by a thermoelectron-radiating material 12 heated at 1,600°C or more. The thermoelectron-radiating material 12 is connected to the negative pole of a DC power source 16, while a substrate 13 is connected to the positive pole. By the use of the DC power source 16, a DC plasma is generated between the thermoelectron-radiating material 12 and the substrate on a substrate-supporting table 14. The activation of the raw material gas is promoted by the formation of plasma in addition to the activation by the thermoelectron-radiating material. In Fig. 2, reference numeral 15 designates a vacuum exhaust port, reference numeral 17 designates an AC power source for heating the thermoelectron-radiating material, reference numeral 19 designates an external heating furnace, reference numeral 20 designates an insulating seal, and reference numeral 21 designates the generated plasma.

Fig. 3 shows an apparatus having a construction fundamentally similar to that shown in Fig. 2, except that a substrate-supporting table 22 incorporating a cooling mechanism is employed, so that various kinds of coolant (for example, water, H₂, He, oils, liquefied nitrogen and the like) may flow through the table 22 from outside the reaction tube. The cooling capacity of the table may be changed, whereby the surface temperature of the substrate can be freely adjusted. The same reference numerals have been used in Figs. 2 and 3 to designate the same components.

An invention technically akin to the present invention has been disclosed in JP-A-60-221395, in which diamond is synthesized by exposing a substrate to a shower of electrons by the use of a direct current power source in addition to the thermal filament method. It has been said that the growth speed is increased, and diamond having a high completeness can be obtained by the use of this method. Since, in this method, a shower of electrons, not a plasma, is used, it is characterised by passing an electron current of a suitable value between the filament and the substrate, this being a small value of 20 to 30 mA based on a substrate size of 25 to 100 mm². On the contrary, in the method embodying the present invention, a plasma is formed, the generating condition of which can be clearly confirmed. That is to say, the present method is greatly different from that disclosed in Japanese Patent JP-A-60-221395, not only in respect of the above described suitable value of the electron current flowing between the filament and the substrate, but also because a large plasma current density of 50 to 1,000 mA/cm² is used.

Another special feature of the present method is that a pressure in the formation of plasma is selected at a remarkably high range to an extent of 6.67 to 66.66 KPa (50 to 500 Torr), contrary to a conventional DC plasma.

Diamond obtained by the thermoelectron-radiating material CVD method is inferior to diamond obtained by the microwave plasma CVD method in film quality. The reason why diamond obtained by the thermoelectron-radiating material CVD method contains carbon having a form other than diamond at a ratio larger than diamond obtained by the microwave plasma CVD method is not clear. However, it appears that a hydrogen radical concentration which acts to selectively remove carbon other than diamond depositing together with diamond, is smaller in the thermoelectron-radiating material CVD method than in the microwave plasma CVD method.

It also appears that a concentration of a metal radical having a SP³ hybrid orbit, thought to be necessary for the formation of diamond in the thermoelectron-radiating material CVD method, is smaller than in the microwave plasma CVD method. In addition, it appears that, since the activation of the raw material gas is carried out merely by the thermal decomposition in the thermoelectron-radiating material CVD method, ions do not exist in an activated species, unlike the case in which a plasma is formed. Also, the concentration of the formed radical is low, which is thought to be disadvantageous for the synthesis of diamond having a high completeness.

On the contrary, according to the method for synthesizing diamond embodying the present invention, it is thought that an excitation level of the raw material gas is significantly improved by using a DC discharge plasma in addition to the thermal decomposition of the raw material gas by the thermoelectron-radiating material heated at a high temperature. Thus, the activation of the reaction gas by the decomposition and excitation can be further promoted, the energy of the activated raw material gas is increased, the proportion of the activated gas is increased relative to the non-activated raw material gas, and the useful life of the activated gas is prolonged, so that the deposition of graphite and amorphous carbon having a form other than that of diamond is suppressed, thus obtaining a diamond film having a high completeness.

The method embodying the present invention is also characterised in that the formation of DC discharge plasma is carried out in an arc discharge range of 6.67 to 66.66 KPa (50 to 500 Torr), in which the DC glow discharge is usually not generated. Since thermoelectrons can be easily drawn from the thermoelectron-radiating material by connecting the thermoelectron-radiating material to a negative pole while the substrate is connected to a positive pole, and applying a voltage using a DC power source, the DC glow discharge can be stably maintained at such a high pressure. A plasma formed at such a high pressure is characterised by a reduction in the difference between the electron temperature and the gas temperature, and by an increase in the gas temperature in comparison with those of plasmas formed at a low pressure.

According to the present invention, it is essential for the manufacture of diamond having a high completeness to form a plasma under such conditions, although the reason for this is not clear.

In the present invention, solid carbon or hydrocarbons, or hydrocarbons containing O and N in a bonding group, or carbon tetrachloride, can be used as the carbon source. In addition, a mixture of the above described carbon sources and hydrogen can be used as the raw material gas. In the case where solid carbon is used as the carbon source, carbon is preferably used as the thermoelectron-radiating material.

Furthermore, Ar, Kr, Xe, Rn and N₂, which do not take part in the reaction, gases other than those above described may be used in combination as the gas to be introduced into the reaction vessel. Since these gases have a low thermal conductivity, then can be used as a coolant gas for the substrate, and they also act to adjust the strength of the plasma.

Since a superior thermoelectron-radiating capacity, a low vapour pressure at a high temperature, and a high melting point, are required for the thermoelectron-radiating material, high-melting point metals, such as W, Ta and Mo, LaB₆, graphite and the like, are preferably used.

In addition, the thermoelectron-radiating material can take the form of a spiral filament, a plurality of linear filaments extended in parallel, tensioned linear filaments, linear filaments combined in mesh, and a uniform thermoelectron-radiating electrode having a large area.

The thermoelectron-radiating material is heated to 1,600°C or more when used. If thermoelectron-radiating material is used at temperatures lower than 1,600°C, graphite and amorphous carbon are predominantly deposited. In addition, in order to stably generate and maintain a plasma at a pressure of 6.67 KPa (50 Torr) or more, the thermoelectron-radiating material is preferably heated to a higher temperature, because a sufficient amount of electrons is required to be radiated.

The pressure within the reaction vessel is preferably selected at 6.67 KPa (50 Torr) or more but 66.66 KPa (500 Torr) or less. If the pressure exceeds 66.66 KPa (500 Torr), the stable maintenance of the plasma becomes difficult. On the contrary, if the pressure is lower than 6.67 KPa (50 Torr), the gas temperature within the formed plasma is lowered, whereby the manufacture of diamond having a high completeness, which is an effect of the present invention, cannot be attained. The reason for this is not clear, but it appears that activated species formed by the generation of a plasma are different in kind and concentration. An increase in the gas pressure is effective also for increasing the nucleus-forming density of diamond. In particular, it is desirable, for a diamond film for use in a cutting tool, that the adhesion between the substrate and the diamond film is strong, and in order to increase the adhesion, a high-temperature treatment is preferably carried out. However, if the coating conditions of diamond are selected so as to raise the surface temperature, the nucleus-forming density is reduced, so that it becomes difficult to form a diamond film comprising fine particles at a pressure of 6.67 KPa (50 Torr) or less in view of the high-temperature treatment.

It is one of the most important constituent factors that the DC plasma has a suitable strength range. The preferable electrical power density is 5 W/cm² or more but 200 W/cm² or less, but it is not restrictive if substrate-cooling measures are taken. The strength of the DC plasma is dependent upon the gaseous atmosphere, the shape of the filament, the shape of the substrate, the shape of the substrate-supporting table, the shape of the counter-pole, the arrangement of the filament relative to the counter-pole, the temperature of the filament, the output of the DC power source, and the like. In addition, regarding the plasma-generating state, a plasma-radiating state is observed in a slight range adjacent to the surface of the supporting table carrying the substrate, at a pressure exceeding 6.67 KPa (50 Torr), in the case where the supporting table is larger than the substrate. Therefore, it is preferable that the strength of a plasma is expressed as a direct current electric power applied to a unit area of the surface exposed to the plasma. This is because, if the electrical power is smaller than 5 W/cm², the film quality-improving effect of the present invention resulting from the simultaneous use of DC plasma is reduced, and, furthermore, if the electrical power is larger than 200 W/cm², the effect of plasma-etching is increased, whereby the deposition rate of diamond is remarkably reduced.

In addition, the simultaneous use of the DC plasma has the effect of making significantly finer the crystalline particles in the formed diamond film, and this effect is increased with an increase of the electrical power applied. The treatment at a high temperature usually leads to an enhancement in the growth speed of diamond particles and the formation of a diamond film comprising rough and large crystalline particles, but the treatment at a high gas pressure, in addition to the simultaneous use of DC plasma, led to such an astonishing effect that a fine structure of 0.3µm can be obtained, even at a high treatment temperature exceeding 1,000°C.

Since it is efficient for the improvement of performance to form a fine film even at a high temperature in the case of cutting tool, the application of a diamond film according to the present invention led to an epoch-making improvement in performance of cutting tools in comparison with those of the conventional cutting tools obtained by conventional coating methods.

Also, regarding electrical resistance, a diamond film formed by the conventional w-filament CVD method was inferior to that formed by the microwave plasma CVD method. However, by employing the method embodying the present invention, the electrical resistance was remarkably increased, and a diamond film, which was superior to that obtained by the microwave plasma CVD method, could be obtained.

In addition, since the present invention is similar to the thermoelectron-radiating material CVD method with regard to the fundamental construction of the apparatus, a plural treatment and large area-coating are possible by using a plurality of filaments. That is to say, the method embodying the present invention is a coating process which is also suitable for mass production.

In addition, according to the present invention, diamond having an excellent shape and a remarkably high completeness and containing hardly any impurities other than diamond, such as amorphous carbon, can be deposited at high-speed to manufacture a bulk material of polycrystalline diamond.

It is thought that, for the high-speed coating of diamond, it is only necessary to increase a concentration of carbon as a raw material of diamond in the reaction system, thereby increasing the supersaturation ratio of diamond. Practically speaking, for example in a system of H₂ and CH₄, it is only necessary to increase the partial pressure of methane to increase the concentration of methane or the total pressure.

However, in general, according to the thermoelectron-radiating material CVD method and the microwave plasma CVD method, in the case where H₂ and CH₄ are used as raw material sources, diamond having an excellent shape can be synthesized at a CH₄- concentration of several % or less, and a pressure of 13.33 KPa (100 Torr) or less. If the concentration of CH₄ and the pressure are increased above the above mentioned values, the synthesis of diamond having an excellent shape and containing hardly any amorphous carbon becomes impossible. A reason for this appears to be that the ratio between the methyl radical and atomic hydrogen generated by exciting and activating the raw material gas is suitable for the synthesizing diamond.

However, in the process using the thermal activation by the thermoelectron-radiating material heated to an extremely high temperature together with the activation by the DC plasma embodying the present invention, diamond having an excellent shape can be synthesized even though the pressure is several tens of KPa (hundred Torr), and the ratio of the number of carbon atoms to the number of hydrogen atoms contained in the raw material gas exceeds 1 % (for example CH₄ of 2 % in a H₂ - CH₄ system). This is achieved by selecting the temperature of the thermoelectron-radiating material to be 2,200°C or more, selecting the DC electrical power applied to be 50 W/cm³ or more per unit volume of plasma-forming space, and maintaining the temperature of the heated substrate at 850°C or more but 1,100°C or less by adjusting the cooling capacity of the supporting table. Astonishingly, this is possible up to a value for the above described ratio of 10 %. High-speed coating showing a deposition speed of 20µm/hr or more is possible at such a high carbon-concentration.

In addition, since the nucleus-forming density is remarkably increased, a fine film can be obtained at a high temperature without applying a grating treatment to the substrate.

As a result, a superthin film of about 0.1 µm thick can be formed.

A reason for this appears to be that, since a large electrical power is applied at a high pressure to generate a plasma having a high energy-density, and a temperature of the thermoelectron-radiating material higher than that in the conventional method is used, the level of the thermal activation is also increased, and the ability or capability to excite and activate the raw material gas is remarkably improved. Thus, a large quantity of methyl radical and atomic hydrogen are formed whilst a suitable balance is maintained therebetween. This is contrary to the conventional method, in which the ratio of the formed methyl radical to atomic hydrogen is out of the suitable range, so that the synthesis of diamond having an excellent shape and hardly containing any amorphous carbon has been impossible, with an increase in the quantity of carbon in the raw material gas. As a result, the synthesis of diamond having an excellent shape and a remarkably high completeness, and hardly containing any amorphous carbon, becomes possible with the present method.

In addition, since the DC plasma having high energy-density generated by applying a large electrical power at a high pressure according to the present invention is distributed not only on a surface of the substrate, but also in a space between the surface of the substrate and the thermoelectron-radiating material, the DC electrical power to be applied is preferably prescribed by an electrical power per unit volume of the plasma-forming space. The effect of the present invention cannot be achieved clearly until a DC electrical power of 50 W/cm³ is selected, that is to say the high-speed coating at a rate of 20µm/hr or more is impossible.

Moreover, if the ratio of the number of carbon atoms to the number of hydrogen atoms in the raw material gas is less than 1 %, the high-speed coating similarly becomes impossible, even though the excitation level is high. On the contrary, if said ratio exceeds 10 %, the synthesis of diamond having a high completeness becomes impossible.

Furthermore, if the temperature of the thermoelectron-radiating material is lower than 2,200°C, plasma having a high energy-density is difficult to stably maintain at such a high pressure.

In addition, in order to synthesize diamond having an excellent shape and hardly containing any amorphous carbon, the surface temperature of the substrate is preferably selected to be 850°C or more but 1,100°C or less. If the surface temperature of the substrate falls outside this range, the amorphous carbon content is increased.

Since an advantage of the present invention is that the nucleus-forming density of diamond is remarkably increased, in addition to the above described advantage that the high-speed coating of diamond becomes possible, the pretreatments of the substrate, such as grating and etching, which have been required, become quite unnecessary. Thus a uniform and fine (having a particle size of 1µm or less) diamond film can be synthesized, even on a mirror-finished single crystalline Si wafer.

In addition, since the nucleus-forming density is remarkably large, the synthesis of continuous thin film of 0.1µm thick is also possible. Accordingly, it can be said that the method embodying the present invention is advantageous for the synthesis of a remarkably thin film.

Moreover, one of the special features of the present invention is that the thermoelectron-radiating material is used as a thermal cathode for generating a DC plasma having a high energy-density. The construction of the thermal cathode can be freely modified, and also an electrode having a large area can be easily used. Accordingly, a large excitation source having a high excitation ability or capability can be produced in a space which renders possible large-area high-speed coating and uniform high-speed coating. Moreover, it can be said that the present invention is, industrially, a very valuable process in view of remarkably simple construction of the apparatus and the inexpensive nature of the apparatus itself.

The present invention will now be described in detail with reference to some preferred embodiments.

### Example 1

A substrate, comprising a Mo plate (10 mm x 10 mm x 1 mm) having its surface polished with diamond abrasive grains #5000, was coated with diamond in apparatus as shown in Fig. 2. Firstly, the interior of the reaction vessel was evacuated to 1.33 x 10⁻⁴ KPa (10⁻³ Torr) or less, and then a gaseous mixture comprising CH₄ and H₂ in a ratio of 1 : 100 was introduced into the reaction vessel as a raw material gas at a rate of 200 ml/min. Subsequently, the surface temperature of the substrate was adjusted to 980°C by heating a W-filament used as a thermoelectron-radiating material at 2,000°C or more and simultaneously using an outside heating furnace, whilst maintaining the pressure within the reaction vessel at a specified value. In this example, the distance between the filament and the substrate was selected at 8 mm. Subsequently, a specified electrical power was applied from a DC power source. Since the application of the electrical power leads to a rise in the substrate temperature, the filament temperature was reduced to maintain the substrate temperature constant. The coating time was selected as 5 hours. The coating conditions and the characteristics of the coated film are shown in Table 1.

**Table 1**

| Sample No. | Pressure (Torr)KPa | Electrical power applied (W) | Electrical resistivity (Ohm·cm) | Crystal grain µm (micron) | Note |
|---|---|---|---|---|---|
| 1* | (30)4.00 | 50 | 10⁹ - 10¹⁰ | 2 - 3 | |
| 2 | (50)6.67 | 50 | 10¹² - 10¹³ | 0.7-1.5 | |
| 3* | (100)13.33 | 0 | 10⁴ - 10⁵ | 3 - 5 | |
| 4 | (200)26.66 | 5 | 10¹⁰ - 10¹¹ | 1 - 2 | |
| 5 | (200)26.66 | 50 | 10¹² - 10¹³ | 0.5- 1 | |
| 6 | (200)26.66 | 150 | " | 0.1-0.3 | |
| 7 | (200)26.66 | 250 | - | - | 1) |
| 8 | (300)40.00 | 50 | 10¹² - 10¹³ | 0.3-0.7 | |
| 9 | (400)53.33 | 50 | " | " | |
| 10 | (500)66.66 | 100 | " | 0.5- 1 | |
| 11* | (550)73.33 | " | - | - | 2) |
| 12* | (40)5.33 | microwave electric power: 300W | 10⁹ - 10¹⁰ | 2 - 3 | |
| 13* | (40)5.33 | 2 | 10⁹ - 10¹⁰ | 3 - 5 | |

In addition, for comparison, the same Mo-substrate was coated for 5 hours at a pressure of 5.33 KPa (40 Torr), an electrical microwave power of 300 W, and a surface temperature of the substrate of 980°C, similarly, as shown in Table 1, in a microwave plasma CVD apparatus of 2.45 GHz, into which a gaseous mixture comprising CH₄ and H₂ in a ratio of 1 : 100 was being introduced at a rate of 200 ml/min. The characteristics of the obtained film are comparatively shown in Table 1. In addition, the electrical resistivity of the diamond film was determined by measuring the V-I characteristics between an electrode produced by coating a first Ti layer and a second Au layer on the diamond film by means of an ion-plating apparatus to form an ohmic contact, and the Mo-plate as the substrate as the other electrode.

The asterisk * shows a comparative example in Table 1. Since, in sample No. 3, the electrical power applied is zero, this corresponds to the sample obtained by the thermoelectron-radiating material CVD method. Sample No. 12 was obtained by the microwave plasma CVD method and sample No. 13 was obtained by the CVD method using an electron shower.

It is found from Table 1 that the electrical resistivity of a diamond film is remarkably increased as a result of the effect of the simultaneous use of plasma by comparing sample No. 3 with other samples. In addition, it is found that a diamond film having a high electrical resistivity, exceeding that of a diamond film obtained by the microwave plasma CVD method such as sample No. 12, can be obtained. It was found from the results of a Raman spectrometric analysis that sample No. 3, without simultaneously using a plasma, contains amorphous carbon, but that the samples obtained by simultaneously using a plasma do not contain amorphous carbon. In addition, regarding the influence of a pressure at the same plasma-electric power, it was found from a comparison of samples Nos. 1,2,5,8 and 9 that the particle size of the diamond film is reduced with an increase in pressure. In addition, it is found from a comparison of samples Nos. 4, 5 and 6 that the particle size of the crystals is reduced with an increase in the electric power applied and the strength of the plasma. Accordingly, a fine structure can be obtained, even at a high temperature, by controlling the pressure and strength of the plasma.

It has been particularly difficult in the microwave plasma CVD method to obtain such a fine structure at a high temperature.

In the Note column of Table 1: -
1) denotes "due to slow deposition speed, film is not formed".
2) denotes "plasma stability cannot be maintained".

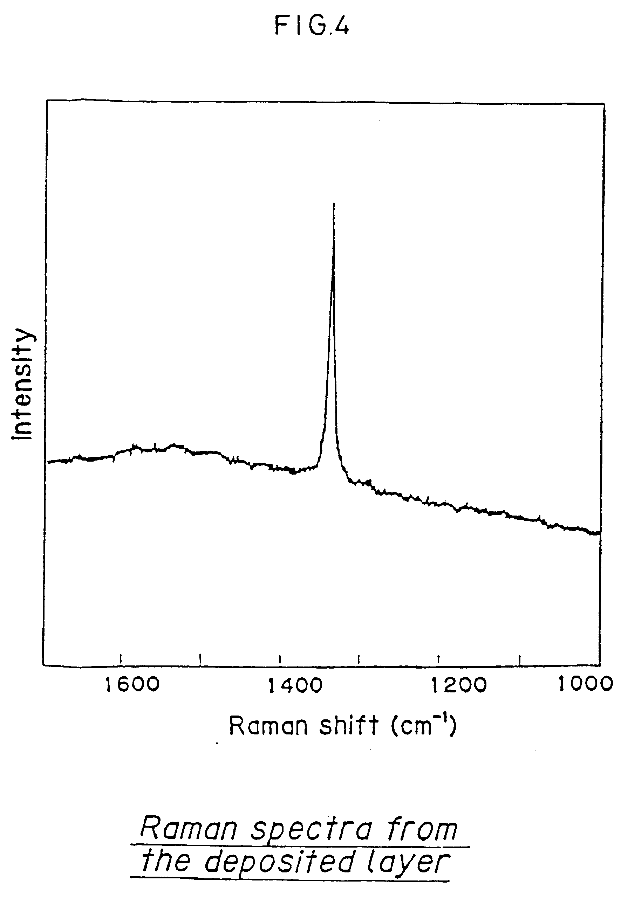

Fig. 4 shows a chart of intensity according to the Raman spectrometric method regarding diamond film obtained by sample No. 6 of Table 1 above.

### Example 2

This example exhibits effects in that, since the apparatus is similar to that used in the thermoelectron-radiating material CVD method in fundamental construction, a plural treatment and a large area coating are possible by using a plurality of thermoelectron-radiating materials, in addition to the possibility of synthesizing diamond having a remarkably high completeness exceeding that in the microwave plasma CVD method.

The coating onto a Mo-substrate of 300 mm x 150 mm x 10 mm was carried out by the use of 30 pieces of the same thermoelectron-radiating material as in Example 1. The Mo-substrate was finished by grinding using a diamond grindstone #600. In this example, in order to control the temperature of respective thermoelectron-radiating materials to a high degree of accuracy, heating power sources were provided independently, so that the control may be independently carried out for respective thermoelectron-radiating materials. However, one side of the electrodes was commonly used for the connection of a DC power source.

Initially, the interior of the reaction vessel was evacuated to 1.33 x 10⁻⁴ KPa (10⁻³ Torr) or less, and then a gaseous mixture comprising CH₄ and H₂ in a ratio of 1 : 100 was introduced into the reaction vessel as a raw material gas at a rate of 200 ml/min. Subsequently, the surface temperature of the substrate was controlled within a range of 900 to 920°C by maintaining a pressure within the reaction vessel of 13.33 KPa (100 Torr), heating a W-filament as thermoelectron-radiating material to 2,000°C, and simultaneously using an outside heating furnace. Then, a voltage of 200 V was applied by means of the DC power source to obtain a plasma electric current of 80 A. That is to say, an electrical power of 35.5 W/cm² was applied. Since the application of this electrical power leads to a rise of the temperature of the substrate, in order to maintain the substrate-temperature constant, the filament-temperature was lowered to control the substrate-temperature. The coating time was selected at 4 hours.

As a result, a diamond film having an average thickness of 10µm was obtained. The fluctuation of film-thickness was 10 % or less. In addition, the diamond film obtained was remarkably superior in quality, that is to say, the size of the crystalline particles was 0.5 to 1.0µm and the electrical resistivity was 10¹¹ to 10 ¹² Ohm.cm. Accordingly, it was found that diamond having a remarkably high completeness and a fine structure could be uniformly coated on a large area.

### Example 3

Diamond was coated on a substrate formed of ISO K-10 carbide alloy (WC-5 % Co) type # SPG 422 on the market, in the same apparatus as in Example 1. At first, the reaction vessel was evacuated to 1.33 x 10⁻⁴ KPa (10⁻³ Torr) or less, and then a gaseous mixture comprising CH₄ and H₂ in a ratio of 1 : 100 was introduced as a raw material gas at a rate of 200 ml/min. Subsequently, the pressure within the reaction vessel was maintained at 13.33 KPa (100 Torr). Then, the surface temperature of the thermoelectron-radiating material was once raised to 950°C by using a W-filament as the thermoelectron-radiating material, heating it at 2,000°C or more and simultaneously using an outside heating furnace. Subsequently, the electrical power applied by a direct current power source was adjusted to 80 W and the surface-temperature of the substrate was adjusted to 950°C by connecting the filament to the negative pole, connecting a cutting tip to be coated to the positive pole and letting a DC plasma start to control the voltage applied and the filament-electric current at the same time. In this example, the distance between the filament and the substrate-surface was selected at 10 mm. A diamond of 7µm thick was obtained after coating for 3 hours The particle size of this diamond film was 0.5 to 1 µm. This substrate is called A. On the other hand, a diamond film of 7µm thick was obtained after coating for 5 hours whilst controlling the surface-temperature of the substrate to 950°C by merely heating a W-filament without simultaneously using a DC plasma. The particle size of this diamond film was 3 to 5µm. This substrate is called B. In addition, an untreated substrate without coating diamond thereon was prepared for comparison. This untreated substrate is called C.

These coated cutting tips were tested under the following cutting conditions:

| | |
|---|---|
| Material to be cut | A1-12%Si alloy |
| Cutting speed | 800 m/min |
| Feed | 0.1 mm/rev |
| Depth of cut | 0.2 mm |
| Holder | FR11R-44A |

As a result, uncoated substrate C exhibited a flank abrasion of 0.35 mm after 15 seconds and also the material being cut exhibited a substantial deposition, while substrate B exhibited a flank abrasion of 0.12 mm after 30 minutes. In addition, substrate A, obtained by simultaneously using the DC plasma according to the present invention, exhibited a flank abrasion of 0.05 mm after cutting for 30 minutes. Thus, the remarkable effect of simultaneously using a DC plasma was confirmed.

### Example 4

Diamond was coated on a Mo-plate (20 mm x 20 mm x 2 mm) as a substrate finished by grinding using diamond grindstone # 600, in apparatus effectively as shown in Fig. 3.

Firstly, the interior of the reaction vessel was evacuated to 1.33 x 10⁻⁴ KPa (10⁻³ Torr) or less, and then a gaseous mixture comprising CH₄ and H₂ was introduced into the reaction vessel at a rate of 300 ml/min. A Ta-filament used as a thermoelectron-radiating material was heated to 2,200°C or more, whilst maintaining a pressure within the reaction vessel at a specified value. Subsequently, an electrical power of a specified value was applied by means of a DC power source to generate a DC high-density energy plasma. The cooling capacity of the substrate-supporting table was changed, while maintaining the temperature of the filament unchanged, to adjust the surface- temperature of the substrate to 950°C. The coating time was selected as 1 hour. Coating conditions and measurement results of the thickness of the coated film are shown in Table 2.

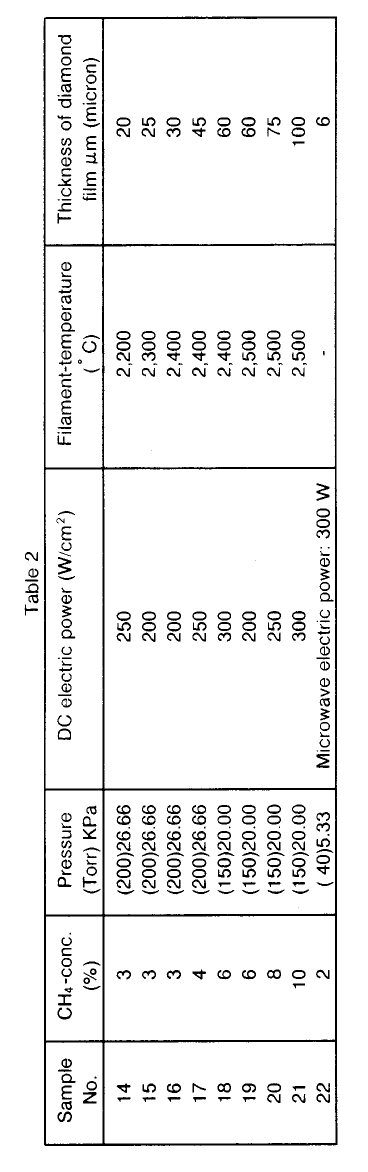

In addition, the same Mo-substrate was subjected to a coating process for 5 hours in a microwave plasma CVD apparatus of 2.45 GHz at a pressure of 5.33 KPa (40 Torr), microwave electric power of 300 W and surface-temperature of the substrate of 950°C, as shown in sample No. 22 in Table 2, introducing a gaseous mixture comprising CH₄ and H₂ at a ratio of 2 : 100 into the reaction vessel at a rate of 200 ml/min. The results of measuring the thickness of the coated film are shown in Table 2.

As described in the above Examples, diamond can be synthesized at a surprisingly high speed by generating a DC high energy density plasma between a thermal cathode formed of a thermoelectron-radiating material heated at a super-high temperature and a substrate at a high pressure, and thermally activating, by use of a plasma, a raw material gas containing a carbon source in high concentration.

### Example 5

A diamond film was formed on a material obtained by coating TiC on a steel plate of 10 cm x 10 cm, in an apparatus shown in Fig. 3. Firstly, the interior of the reaction vessel was evacuated to 1.33 x 10⁻⁵ KPa (10⁻⁴ Torr), and then a gaseous mixture comprising C₂H₆ and H₂ in a ratio of 8 : 100, and B₂H₆ at 1,000 ppm, was introduced into the reaction vessel at a rate of 500 ml/min.

The electrical power was set at 2,000 W by maintaining the pressure within the reaction vessel at 33.33 KPa (250 Torr), using a filament made of Ta, heating it at 2,300°C, and then connecting the filament to a negative pole and the substrate to a positive pole, making a DC plasma start, and adjusting a voltage applied and filament electric current at the same time.

In addition, the surface-temperature of the substrate was adjusted to 850°C, and the diamond film was synthesized for 2 hours.

The diamond film obtained had a thickness of 70µm and contained boron (B) therein.

### Example 6

Diamond was coated on a substrate in the apparatus shown in Fig. 3, using materials as shown in Table 3 under the conditions also shown in Table 3.

Initially, the interior of the reaction vessel was evacuated to 1.33 x 10⁻⁴ KPa (10⁻³ Torr) or less, and then a gaseous mixture, comprising a raw material gas (carbon source) and other gases in a ratio as shown in Table 3, was introduced into the reaction vessel at a rate of 200 ml/min. Subsequently, a thermoelectron-radiating material was heated while maintaining the pressure within the reaction vessel at a specified value to adjust a surface-temperature of a substrate. At this time, the distance between the filament and the substrate was selected at 10 mm.

Subsequently, a specified electrical power was applied for 2 hours from a DC power source to obtain a diamond film having a high completeness and a film-thickness as shown in Table 3.

The diamond film obtained in this Example was tested under cutting conditions using a carbide alloy (WC-5 % Co) prescribed by K-10 of ISO Standard, and a sintered body mainly comprising Si₃N₄ and W as the substrate, selecting a shape of Model No. SPG 422, and adjusting the coating time so that the film-thickness may amount to 6µm. The results are shown in the columns of the cutting test of Table 3.

The cutting conditions were selected as follows:

| | |
|---|---|
| Material to be cut | A1-8 % Si |
| Cutting speed | 1,800 m/min |
| Feed | 0.1 mm/rev |
| Depth of cut | 0.2 mm |
| Cutting time | 2 hours |

The evaluation was carried out on the basis of the amount of abrasion.

In the results of the cutting test, the amount of abrasion is increased in the order of ⓞ , ○ , △ , X, from a tool coated with a diamond film to that which is not coated with a diamond film. X merely exhibited a performance equal to a tool which is not coated with a diamond film.

On the other hand, in the Comparative Examples No. 37 and No. 38 marked with * in Table 3, an amorphous carbon film was obtained.

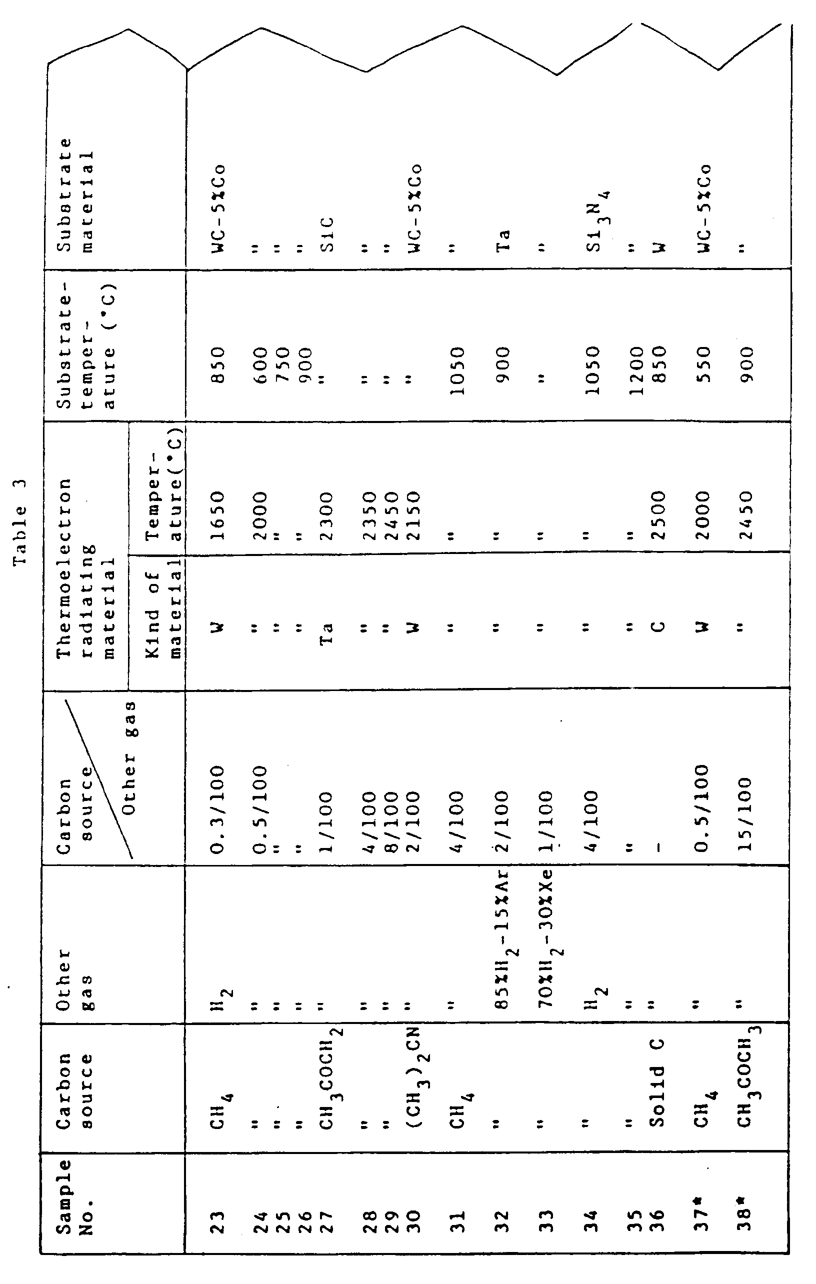

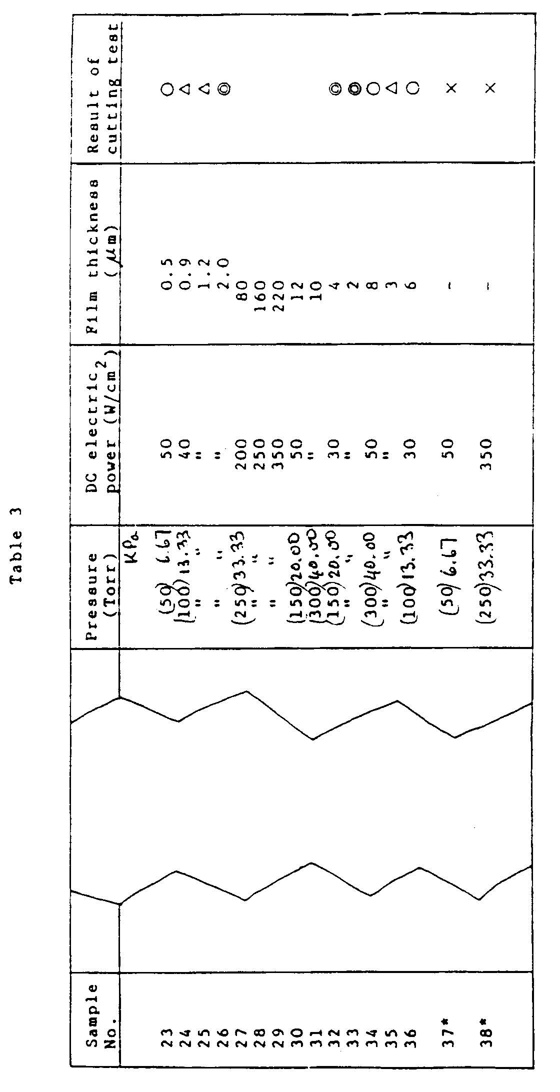

### Example 7

The coating process was carried out in the same manner as in Example 1 except that a gaseous mixture introduced in the initial stage comprises CH₄ and H₂ in a ratio of 0.1 : 100 for 30 minutes, and then the reaction was continued for 5 hours, setting the ratio of CH₄ and H₂ at 1 : 100 to obtain granular diamond on a Mo-plate. Because the nucleus-generating density per unit area is reduced in the initial stage, and subsequently the quantity of carbon fed is increased, diamond is formed merely on the generated nuclei, so that granular diamond can be obtained in a short time.

As above described, diamond having a completeness higher than that obtained by the thermoelectron-radiating material CVD method, and an electrical resistivity exceeding that obtained by the microwave plasma CVD method, can be obtained by using the thermoelectron-radiating material CVD method together with a DC plasma, and generating the plasma at a high gas pressure of 6.67 KPa (50 Torr) or more but 66.66 KPa (500 Torr) or less. Thus, diamond synthesized by the method embodying the present invention can be applied to a field of electronic materials requiring a high insulating property.

In addition, a diamond film of a minute particle size can be synthesized even at a high temperature, so that remarkable improvement in performance can be attained in fields capable of utilizing mechanical properties of diamond, such as cutting tools and abrasion-resisting sliding members.

Moreover, according to the method embodying the present invention, diamond can be synthesized at high-coating speeds of 20µm/h or more, and a bulk material of polycrystalline diamond having an excellent shape and a remarkably high completeness and hardly containing any impurities other than diamond such as amorphous carbon, can be manufactured.

## Claims

1. A diamond film coated on a substrate, characterised in that an average particle size of diamond is 2µm or less and a half-width of a peak of 1334 cm⁻¹ measured by the Raman spectrometric method is 50 cm⁻¹ or less; in that the surface of the diamond film is mainly a (111)-plane, and in that the coated diamond has an electrical resistivity of 10¹⁰ Ohm.cm or more.

2. A method for synthesizing a diamond film in a low-pressure gaseous phase, in which solid carbon or hydrocarbon, or hydrocarbon containing O, N in a bonding group, or carbon tetrachloride, is used as a carbon source, and a raw material gas mixture of said carbon source and hydrogen is activated to deposit a diamond film on a surface of a substrate heated at 600 to 1,200° C, characterised in that the activation of said raw material gas mixture is carried out by a thermoelectron-radiating material heated at 1,600° C or more, the thermoelectron-radiating material being connected to a negative pole of a direct current power source while the substrate to be coated is connected to a positive pole of the source, the source being used to form a plasma at a plasma current density of 50-1000mA/cm² between the thermoelectron-radiating material and the substrate by applying a direct current voltage, the activation by the thermoelectron-radiating material being used together with the activation by the formation of DC plasma, and a pressure within a reaction vessel, in which the plasma is formed, being set at 6.67 KPa (50 Torr) or more but 66.66 KPa (500 Torr) or less.

3. A method for synthesizing a diamond film as set forth in claim 2, characterised in that a substrate-supporting table is cooled by flowing a coolant therethrough from outside of the reaction tube, and the temperature of the heated substrate surface, which is changed by the radiation from the thermoelectron-radiating material, by thermal conduction from the raw material gas and by generated plasma, is controlled quite independently of the coating conditions such as the temperature of the thermoelectron-radiating material and the plasma electric power applied, by adjusting the cooling capacity of the substrate-supporting table in dependence upon said coating conditions.

4. A method for synthesizing a diamond bulk material in a low-pressure gaseous phase, in which solid carbon or hydrocarbon, or hydrocarbon containing O, N in a bonding group, or carbon tetrachloride, is used as a carbon source, and a raw material gas mixture of said carbon source and hydrogen, with the ratio of the number of carbon atoms to the number of hydrogen atoms in the raw material gas mixture being set at 1% or more, but 10% or less, is activated to deposit a diamond bulk material on a surface of a substrate set at 850°C or more but 1,200°C or less, characterised in that the activation of said raw material gas is carried out by a thermoelectron-radiating material set at 2,200°C or more, the thermoelectron-radiating material being connected to a negative pole of a direct current power source while the substrate to be coated is connected to a positive pole of the source, the source being used to form a plasma between the thermoelectron-radiating material and the substrate by applying a direct current voltage, the electric power to be applied for the formation of DC plasma being set at 50W/cm³ or more per unit volume of DC plasma-forming space, the activation by the thermoelectron-radiating material being used together with the activation by the formation of DC plasma, and a pressure within a reaction vessel, in which the plasma is formed, being set at 6.67 KPa (50 Torr) or more but 66.66 KPa (500 Torr) or less.

## Patentansprüche

1. Auf einem Tragermaterial aufgebrachter Diamantfilm,
**dadurch gekennzeichnet**, daß
ein durchschnittlicher Diamantpartikeldurchmesser kleiner oder gleich 2 µm ist und eine nach dem Raman-Spektrometrie-Verfahren ermittelte Halbwertsbreite eines Peaks von 1334 cm⁻¹ den Wert von 50 cm⁻¹ oder weniger hat, daß
die Fläche des Diamantfilms im wesentlichen eine (111)-Ebene bildet, und daß
der Diamantauftrag einen spezifischen elektrischen Widerstand von 10¹⁰ Ohm.cm oder mehr aufweist.

2. Verfahren zur Synthetisierung eines Diamantfilms aus einer Niederdruck-Gasphase, bei dem fester Kohlenstoff oder Kohlenwasserstoff oder Kohlenwasserstoff in einer Verbindung mit Sauerstoff, Stickstoff oder Kohlenstofftetrachlorid als Kohlenstoffbasis verwendet wird, und ein Rohgasgemisch aus der Kohlenstoffbasis und Wasserstoff aktiviert wird, um einen Diamantfilm auf einer Oberfläche eines auf 600 bis 1200 °C aufgeheizten Trägermaterials abzulagern,
**dadurch gekennzeichnet**, daß
die Aktivierung des Rohgasgemisches über ein Thermoelektronen emittierendes Material, das auf 1600 °C oder mehr aufgeheizt ist, ausgeführt wird,
das Thermoelektronen emittierende Material unter Verwendung einer Gleichstromquelle an einen negativen Pol angeschlossen ist, während das zu beschichtende Trägermaterial an einen positiven Pol angeschlossen ist,
ein Plasma mit einer Plasmastromdichte von 50 bis 1000 mA/cm² zwischen dem Thermoelektronen emittierenden Material und dem Trägermaterial durch Anlegen einer Gleichspannung erzeugt wird,
die Aktivierung durch das Thermoelektronen emittierende Material zusammen mit der Aktivierung durch die Erzeugung des Gleichspannungs-Plasmas verwendet wird, und daß
ein Druck innerhalb eines Reaktionsgefäßes, in dem das Plasma gebildet wird, zwischen 6,67 kPa (50 Torr) und 66,66 kPa (500 Torr) eingestellt ist.

3. Verfahren zur Synthetisierung eines Diamantfilms nach Anspruch 2,
**dadurch gekennzeichnet**, daß
ein Trägermaterial-Aufnahmetisch durch Hindurchfließen eines Kühlmittels von außerhalb des Reaktionsgefäßes gekühlt wird, und daß
eine durch die Strahlung des Thermoelektronen emittierenden Materials aufgeheizte und geänderte Oberflächentemperatur des Trägermaterials und die Wärmeleitung vom Rohgasgemisch und dem erzeugten Plasma völlig unabhängig von den Beschichtungsbedingungen gesteuert wird, beispielsweise unabhängig von der Temperatur des Thermoelektronen emittierenden Materials und der zugeführten elektrischen Plasmaenergie, durch Einstellen eines Kühlvolumens eines Kühltisches in Abhängigkeit von den Beschichtungsbedingungen.

4. Verfahren zur Synthetisierung eines Diamant-Schüttgutes in einer Niederdruck-Gasphase, bei dem fester Kohlenstoff oder Kohlenwasserstoff oder Kohlenwasserstoff in einer Verbindung mit Sauerstoff, Stickstoff oder Kohlenstofftetrachlorid als Kohlenstoffbasis genutzt wird, und bei dem ein Rohgasgemisch aus der Kohlenstoffbasis und Wasserstoff mit einem Verhältnis von Kohlenstoffatomen zu Wasserstoffatomen zwischen 1 und 10% aktiviert wird, um ein Diamant-Schüttgut auf einer Oberfläche eines auf 850 bis 1200 C° aufgeheizten Trägermaterials abzulagern,
**dadurch gekennzeichnet,** daß
die Aktivierung des Rohgasgemisches von einem auf 2200°C oder mehr aufgeheizten Thermoelektronen emittierenden Material ausgeführt wird,
das Thermoelektronen emittierende Material unter Einsatz einer Gleichspannungsquelle an einen negativen Pol angeschlossen ist, während das zu beschichtende Trägermaterial an einen positiven Pol angeschlossen ist,
ein Plasma zwischen dem Thermoelektronen emittierenden Material und dem Trägermaterial durch Anlegen einer Gleichspannung erzeugt wird,
die zur Erzeugung des Gleichspannungs-Plasmas aufgewendete elektrische Energie 50 W/cm³ oder mehr pro Volumeneinheit des das Gleichspannungs-Plasma ausbildenden Raums beträgt,
die Aktivierung durch das Thermoelektronen emittierende Material zusammen mit der Aktivierung durch die Erzeugung des Gleichspannungs-Plasmas erfolgt, und daß
ein Druck innerhalb eines Reaktionsgefäßes, in dem das Plasma gebildet wird, zwischen 6,67 kPa (50 Torr) und 66,66 kPa (500 Torr) eingestellt ist.

## Revendications

1. Film de diamant recouvrant un substrat, caractérisé en ce qu'une taille de particule moyenne de diamant est de 2 microns ou moins, et une demi-largeur d'un pic de 1334 cm⁻¹ mesuré par le procédé de spectrométrie Raman est de 50 cm⁻¹ ou moins; en ce que la surface du film de diamant est principalement un plan-(111); et en ce que le diamant déposé a une résistivité électrique de 10¹⁰ Ohm cm ou plus.

2. Procédé pour synthétiser un film de diamant dans une phase gazeuse basse pression, dans lequel on utilise comme source de carbone du carbone solide ou un hydrocarbure, ou un hydrocarbure contenant 0,N dans un groupe de liaison, ou du tétrachlorure de carbone, et un mélange de gaz de matière première de ladite source de carbone et d'hydrogène est activé pour déposer un film de diamant sur une surface d'un substrat chauffé à une température comprise entre 600 et 1.200°C, caractérisé en ce que l'activation dudit mélange de gaz de matière première est réalisée par un matériau émettant des électrons thermiques chauffés à 1.600°C ou plus, le matériau émettant des électrons thermiques étant connecté à un pôle négatif d'une source de puissance à courant continu tandis que le substrat à enduire est connecté à un pôle positif de la source, la source étant utilisée pour former un plasma avec une densité de courant de plasma de 50 à 1.000 mA/cm² entre le matériau émettant des électrons thermiques et le substrat, en appliquant une tension continue, l'activation par le matériau émettant des électrons thermiques étant utilisée simultanément avec l'activation par la formation de plasma en courant continu, et une pression dans une cuve de réaction, dans laquelle le plasma est formé, étant fixée à une valeur comprise entre 6,67 KPa (50 Torr) et 66,66 KPa (500 Torr).

3. Procédé pour synthétiser un film de diamant selon la revendication 2, caractérisé en ce qu'un plateau de support du substrat est refroidi par l'écoulement d'un refroidisseur à travers ledit plateau depuis l'extérieur du tube de réaction, et la température de la surface du substrat chauffé qui est modifiée par la radiation provenant du matériau émettant des électrons thermiques, par la conduction thermique à partir du gaz de matière première et par le plasma généré, est contrôlée tout à fait indépendamment des conditions d'enduction, telles qu'une température du matériau émettant des électrons thermiques et une puissance électrique de plasma appliquée, en ajustant une capacité de refroidissement d'un plateau de support et de refroidissement en fonction desdites conditions d'enduction.

4. Procédé pour synthétiser un matériau massif de diamant dans une phase gazeuse à basse pression, dans lequel on utilise comme source de carbone du carbone solide, ou un hydrocarbure, ou un hydrocarbure contenant 0,N dans un groupe de liaison, ou du tétrachlorure de carbone, et un mélange de gaz de matière première de ladite source de carbone et d'hydrogène est activé pour déposer un matériau massif de diamant sur une surface d'un substrat ayant une température comprise entre 850°C et 1.200°C, un rapport d'un nombre d'atomes de carbone à celui d'atomes d'hydrogène dis le mélange de gaz de matière première étant fixé à une valeur comprise entre 1% et 10%, caractérisé en ce que l'activation dudit gaz de matière première est réalisée par un matériau émettant des électrons thermiques porté à 2.200°C ou plus, le matériau émettant des électrons thermiques étant connecté à un pôle négatif d'une source de puissance à courant continu tandis que le substrat à enduire est connecté à un pôle positif de la source, la source étant utilisée pour former un plasma entre le matériau émettant des électrons thermiques et le substrat par application d'une tension continue, la puissance électrique appliquée pour la formation du plasma à courant continu étant fixée à 50W/cm³ ou plus par unité de volume d'espace formant un plasma à courant continu, l'activation par le matériau émettant des électrons thermiques étant utilisée simultanément avec l'activation par la formation de plasma à courant continu, et une pression dans une cuve de réaction, dans laquelle le plasma est formé, étant fixée à une valeur comprise entre 6,67 KPa (50 Torr) et 66,66 KPa (500 Torr).
